# EUROPEAN PATENT SPECIFICATION

(11) **EP 1 542 354 B1**
(45) Date of publication and mention of the grant of the patent: **03.02.2021**
(21) Application number: 04029201.3
(22) Date of filing: 09.12.2004
(51) Int. Cl.: H03B 5/18

(54) **Integrated ultra low noise microwave wideband push-push vco**
Spannungsgesteuerter-, Push-push-, Breitband-, Mikrowellenoszillator mit sehr niedrigem Rausch
Oscillateur à micro-ondes push-push commandé en tension intégrée, à bande large et avec un niveau de bruit très bas

(30) Priority: 09.12.2003 US 527957 P; 11.12.2003 US 528670 P; 19.04.2004 US 563481 P
(43) Date of publication of application: 15.06.2005
(73) Proprietor: Synergy Microwave Corporation, Paterson, NJ 07504 (US)
(72) Inventor: Rohde, Ulrich L., Upper Saddle River, NJ 07458 (US); Poddar, Ajay Kumar, Fairlawn, NJ 07410-6110 (US); Rebel, Reidmund, Elmond Park, NJ 07456 (US)
(74) Representative: Körfer, Thomas

(56) References cited:
- US-A- 4 527 130
- US-A- 4 692 714
- US-A- 5 402 087

## Description

### CROSS-REFERENCE TO RELATED APPLICATIONS

This application claims the benefit of the filing date of United States Provisional Patent Application Nos. 60/527,957, filed December 9, 2003, 60/528,670, filed December 11, 2003, and 60/563,481filed April 19, 2004,. This application is also a continuation-in-part of United States Patent Application No. 10/937,525 filed September 9, 2004, disclosure of which is incorporated herein by reference.

### BACKGROUND

A voltage controlled oscillator (VCO) or oscillator is a component that can be used to translate DC voltage into a radio frequency (RF) voltage or signal. In general, VCOs are designed to produce an oscillating signal of a particular frequency 'f' corresponding to a given tuning voltage. The frequency of the oscillating signal is dependent upon the magnitude of a tuning voltage Vₜᵤₙₑ applied to a tuning diode network across a resonator circuit. The frequency 'f' may be varied from fₘᵢₙ to fₘₐₓ and these limits are referred as the tuning range or bandwidth of the VCO. The tuning sensitivity of the VCO is defined as the change in frequency over the tuning voltage and it is desirable to tune the VCO over a wide frequency range with a small tuning voltage range.

A high frequency signal can be generated either by an oscillator operating at a fundamental frequency or a harmonic oscillator. An oscillator operating at the fundamental frequency typically suffers from a low Q-factor, insufficient device gain and higher phase noise at a high frequency of operation. In contrast, harmonic oscillators may be operated at a lower frequency, and generally include a high Q-factor, high device gain and low phase noise. Harmonic oscillators, however, are generally more costly and typically employ YIG resonators to achieve their operational benefits.

The cascade structure and the parallel structure are the two configurations known for the harmonic oscillators. The cascade structure supports second-harmonic oscillation based on frequency-doubling. On the other hand, the parallel structure supports N^{th} harmonic frequency oscillations (N-push/push-push oscillator topology as a N^{th} harmonic oscillator) based on the coupled-oscillator approach. The frequency doubler and other means of up-conversion may provide a practical and quick solution to generate a high frequency signal from an oscillator operating at a lower frequency, however, they may also introduce distortions and provide poor phase noise performance.

The magnitude of the output signal from a VCO depends on the design of the VCO circuit and the frequency of operation is determined by a resonator that provides an input signal. Clock generation and clock recovery circuits typically use VCOs within a phase locked loop (PLL) to either generate a clock from an external reference or from an incoming data stream. VCOs are therefore often critical to the performance of PLLs. In turn, PLLs are essential components in communication networking as the generated clock signal is typically used to either transmit or recover the underlying service information so that the information can be used for its intended purpose. PLLs are particularly important in wireless networks as they enable the communications equipment to quickly lock-on to the carrier frequency onto which communications are transmitted.

The popularity of mobile telephones has renewed interest in and generated more attention to wireless architectures. This popularity has further spawned renewed interest in the design of low noise wideband oscillators. The recent explosive growth in the new families of cellular telephones and base stations using universal mobile telephone systems (UMTS) has stirred a need for developing an ultra-low noise oscillator with a fairly wide tuning range. The demands of wideband sources have generally increased telescopically because of the explosive growth of wireless communications. In particular, modern communication systems are typically multi-band and multi-mode, therefore requiring a wideband low noise source that preferably allows simultaneous access to DCS 1800, PCS 1900 and WCDMA (wideband code division multiple access) networks by a single wideband VCO.

The dynamic operating range and noise performance of a VCO may limit or affect the performance of the PLL itself, which in turn may affect the performance of the device in which the PLL is employed, e.g., RF transceivers, cell phone, modem card, etc. Broadband tunability of VCOs represents one of the more fundamental tradeoffs in the design of a VCO, impacting both the technology and the topology used. The dynamic time average quality factor (i.e., Q-factor) of the resonator as well as the tuning diode noise contribution affect the noise performance of a VCO. Furthermore, the dynamic loaded Q is, in general, inversely proportional to the operating frequency range of the VCO.

Despite the continuous improvement in VCO technology, low phase noise typically remains a bottleneck and poses a challenge to RF transceiver (transmitter - receivers) design. This is typically considered due to the more demanding parameters of the VCO design: low phase noise, low power consumption and wide frequency tuning range.

In LC-resonator based VCOs, phase noise and power consumption typically depend primarily on the time average loaded Q-factor of the resonator circuit and the nonlinearities associated with the tuning network, which typically employ varactors. The frequency tuning range is determined by the usable capacitive tuning ratio of the varactor and parasitic associated with the tuning network because the parasitic deteriorates and limits the effective tuning capability of the varactor at a high frequency. As the loss-resistance of the tuning network (e.g., varactor and resonator) determines the quality factor, attention is usually paid to the resistive behavior. The frequency range over which a coupled resonator circuit can be tuned by means of the tuning diode depends on the useful capacitance ratio of the tuning diode and on the parallel and series capacitance present in the circuit.

As the frequency for wireless communication shifts to higher and higher frequency bands, generation of an ultra-low noise, wideband, thermally stable and compact signal source at a relatively low cost becomes more and more challenging due to the frequency limitations of the active devices and broadband tunability of the tuning diode. In the past, wide tuning range and good phase noise performance were generally considered to be opposing requirements due to the problem of the controlling the loop parameters and the dynamic loaded Q of the resonator over the range of wideband operation.

Typically, the phase noise of a microstrip line resonator-based wideband VCO is -80dBc/Hz @10 KHz (kilo-hertz) for a frequency band of 1600 - 3200 MHz (mega hertz) operating at 15V (volts), 45 mA (milli-ampere). A YIG resonator based VCO offers wideband tunability with an external DC magnetic field, but at a high price. In addition, the YIG resonator based VCO is not amenable to integration in chip form.

Document US 4,692,714 A relates to a microwave frequency oscillator utilizing a push-push configuration to provide a low noise highly stable output signal at twice the frequency of a single resonator. The single resonator is connected in the feedback loop of two amplifiers. Additional circuit elements ensure the proper oscillation conditions and relative phase are maintained.

Document US 4,527,130 A relates to a push-pull microwave oscillator circuit, including two transistors, for producing the second harmonic of a fundamental frequency at a symmetry point of the circuit, which is connected to the transistors through identical arrangements of circuit elements. Further means for tuning and phase comparison are also provided with the oscillator circuit.

Document US 5,402,087 A relates to a voltage controlled push-push oscillator having a variable frequency output over a range of microwave frequencies. The oscillator comprises two transistors whose collectors are tied together and an inductive reactance is provided across the base and collector of each of the transistors. The emitters of the transistors are connected to opposite phases of a resonator that is bisected to provide an output tap.

Thus, there is a need for a wideband oscillator, preferably having octave-band tunability, that offers a cost-effective alternative to the YIG resonator based wideband VCO in the frequency range of the L (0.95-1.5 GHz), S (1.7-2.3 GHz), and C (4-6 GHz) bands.

### SUMMARY OF THE INVENTION

The present invention is defined by the appended independent claim 1 and its further aspects are defined by the appended dependent claims 2-12.

An embodiment of the invention is shown in Fig. 15. Fig. 16 and Fig. 17 show implementation details in order to understand the invention.

### BRIEF DESCRIPTION OF THE DRAWINGS

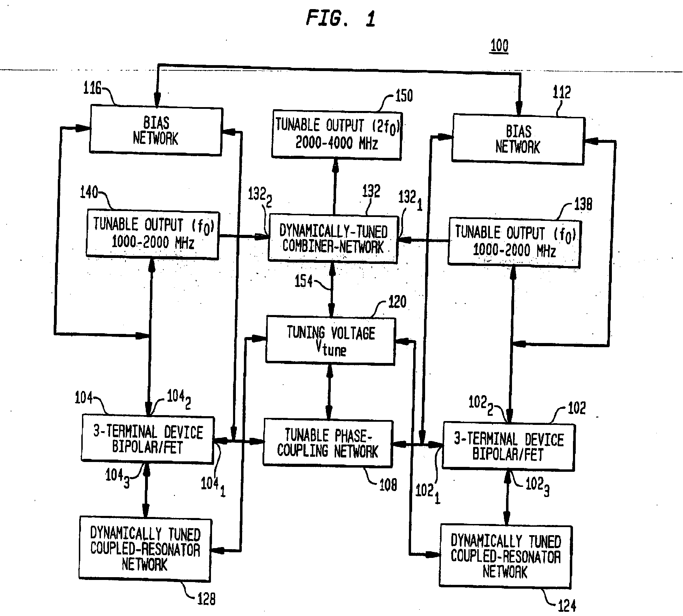

FIG. 1 is a functional block diagram illustrating the modules of a voltage controlled oscillator

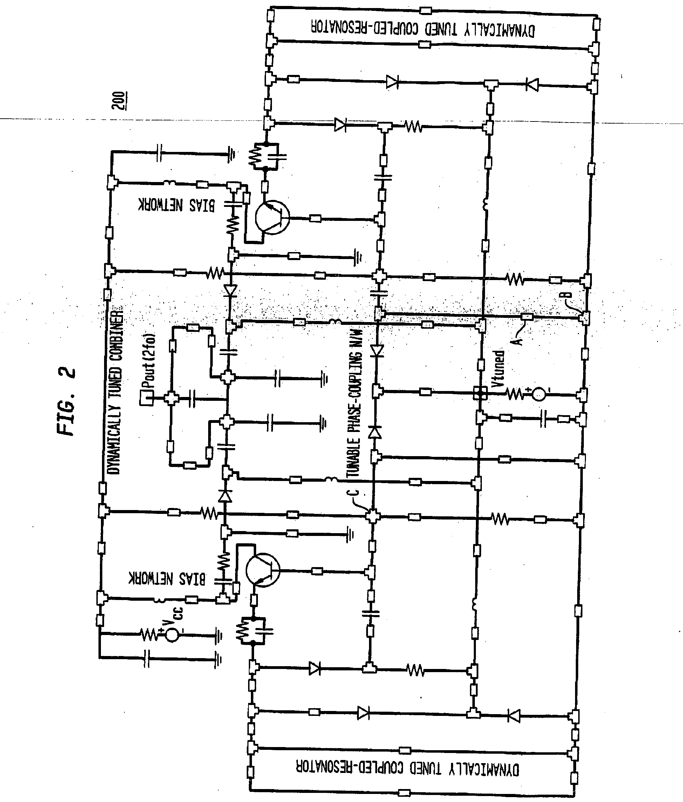

FIG. 2 is a schematic circuit diagram of a VCO

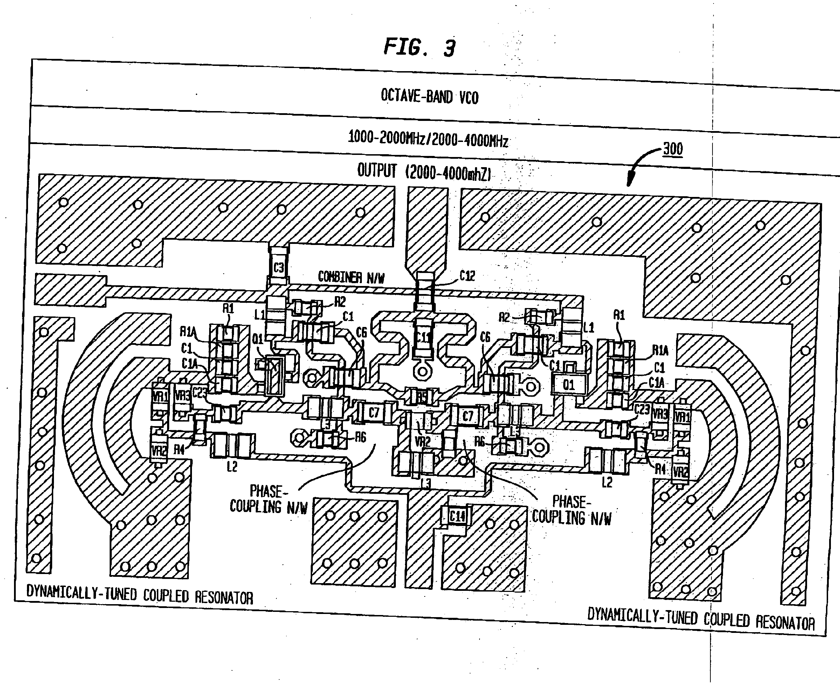

FIG. 3 is a schematic of an integrated circuit comprising a VCO

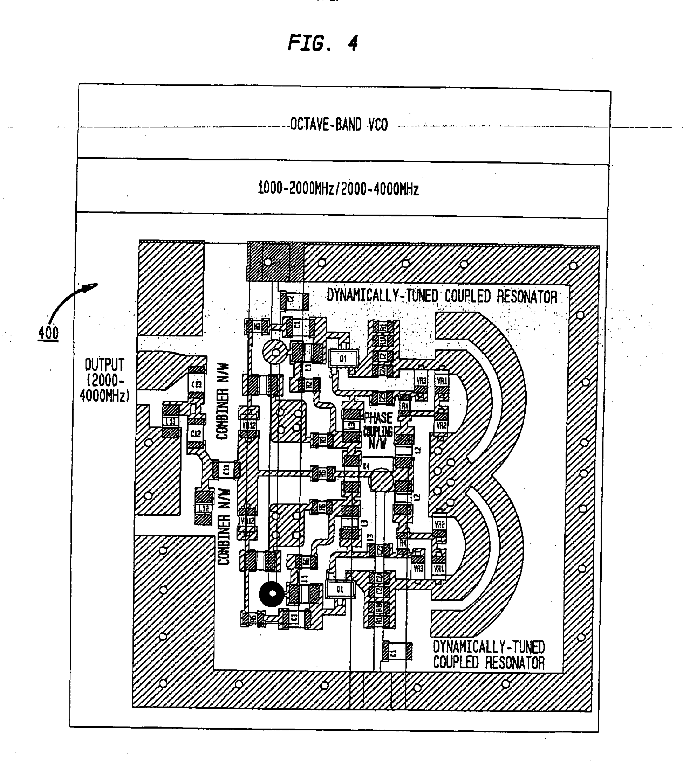

FIG. 4 is a schematic of an integrated circuit comprising a VCO

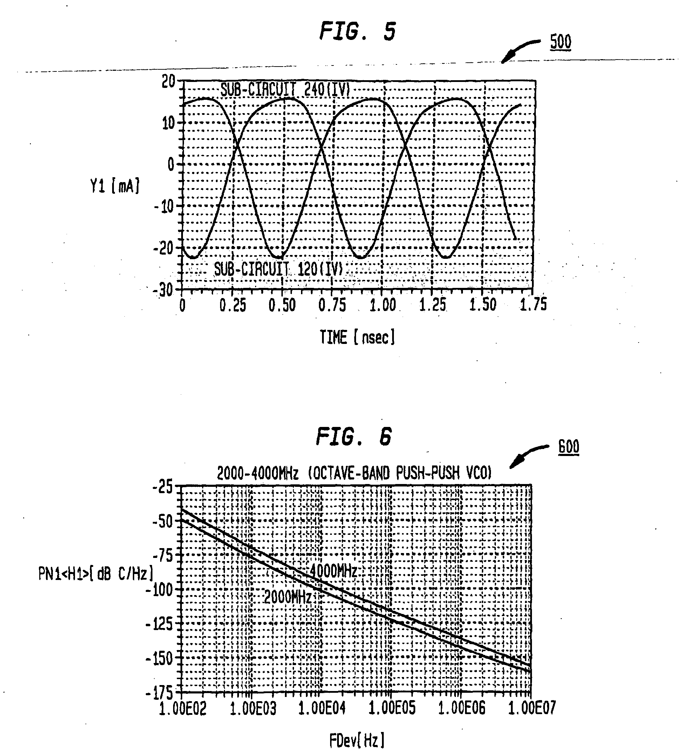

FIG. 5 is a plot of RF-base currents of the sub-circuits of FIG. 3 at the fundamental frequency of operation.
FIG. 6 shows a phase noise plot for a VCO over an octave-band frequency range of 2 GHz to 4 GHz.

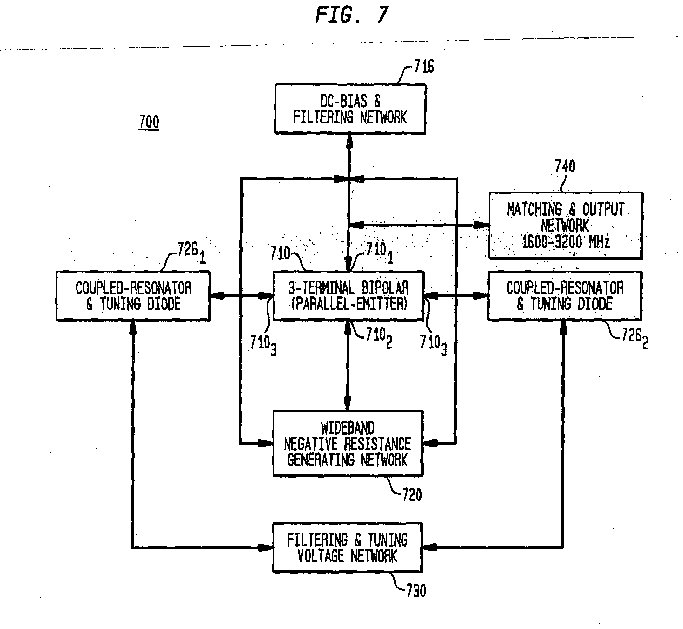

FIG. 7 is a functional block diagram illustrating the modules of a VCO

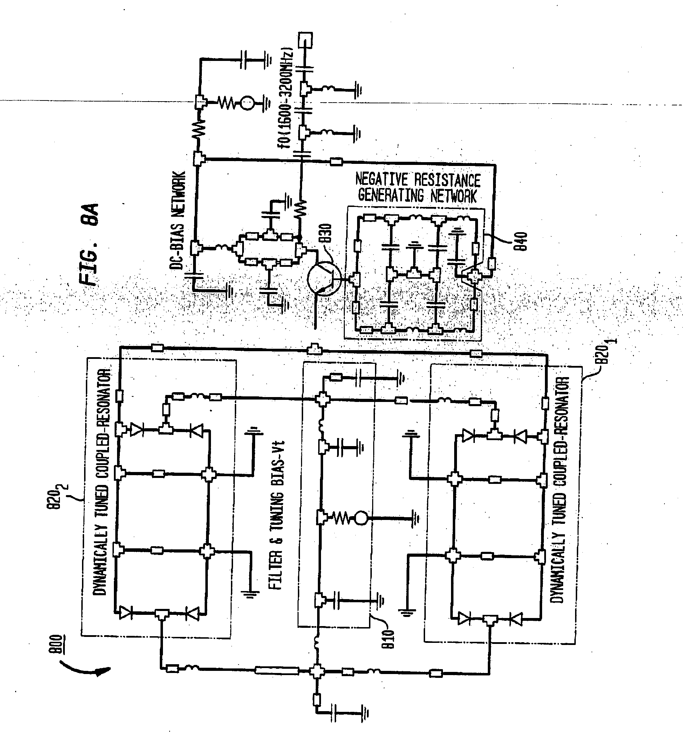

FIG. 8A is a schematic circuit diagram of VCO

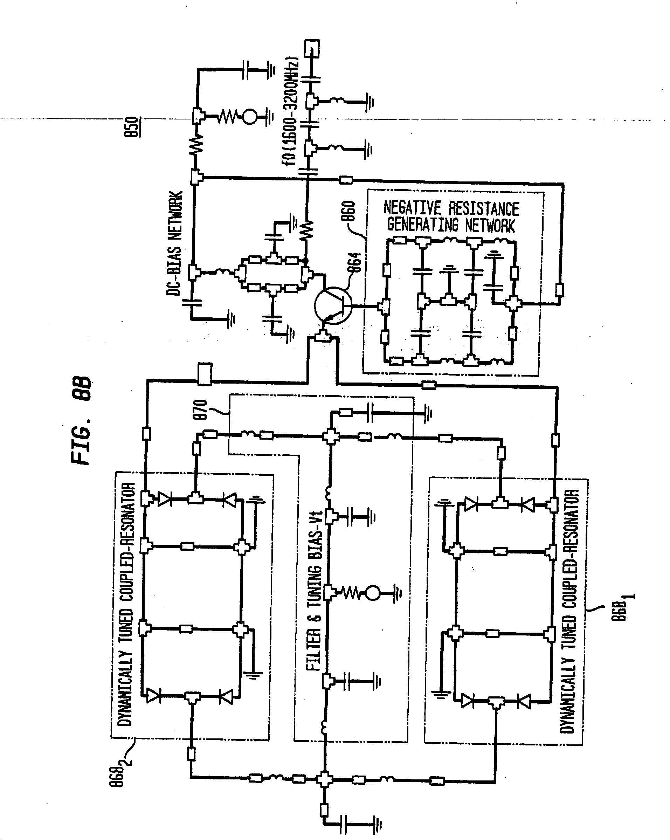

FIG. 8B is a schematic circuit diagram of VCO

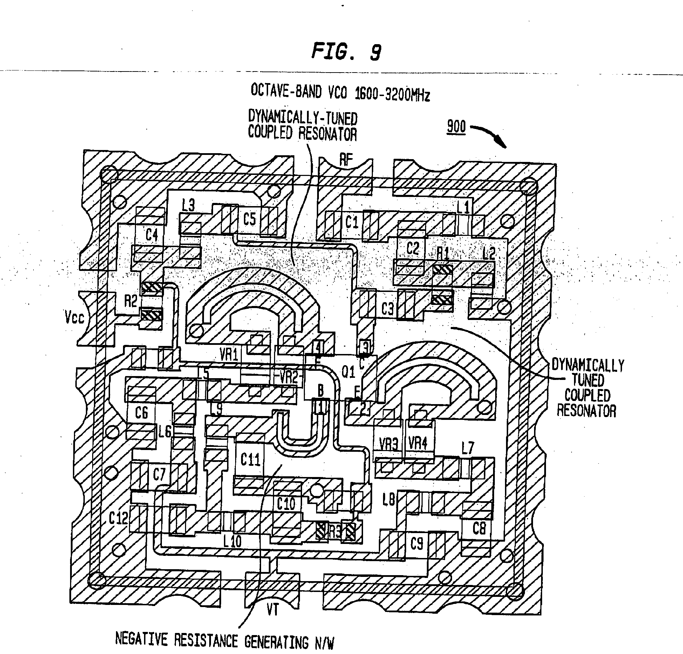

FIG. 9 is a schematic of an integrated circuit comprising a

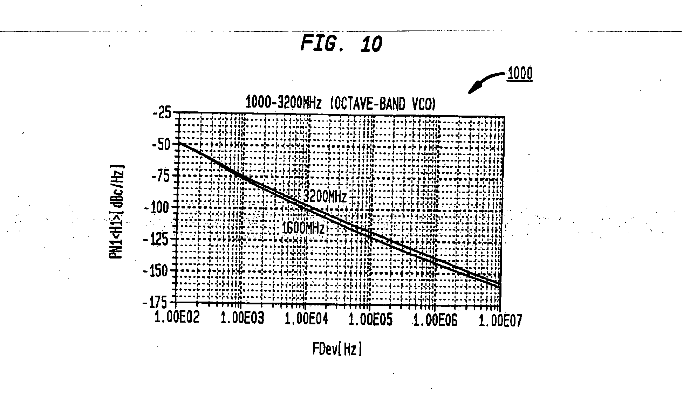

FIG. 10 illustrates a phase noise plot for the octave-band frequency range of a VCO

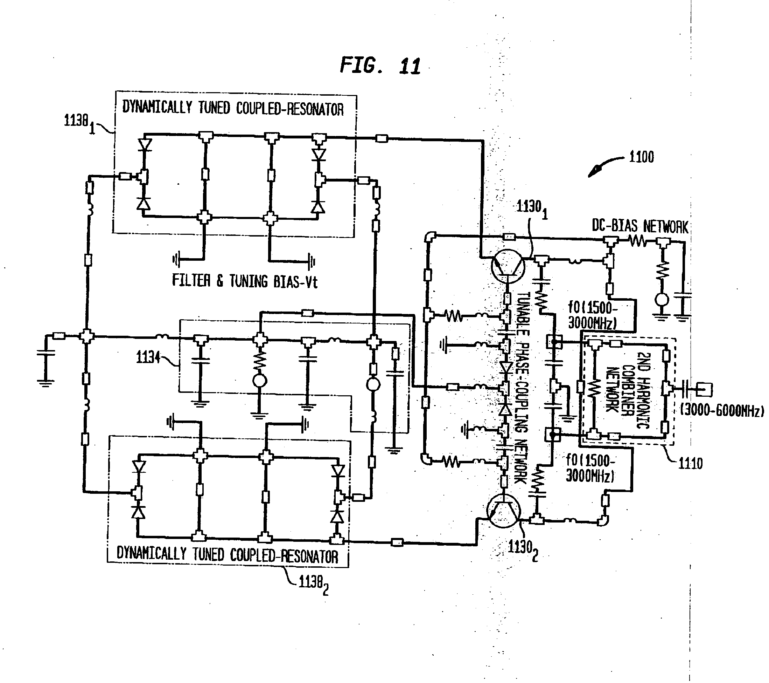

FIG. 11 is a schematic circuit diagram of VCO

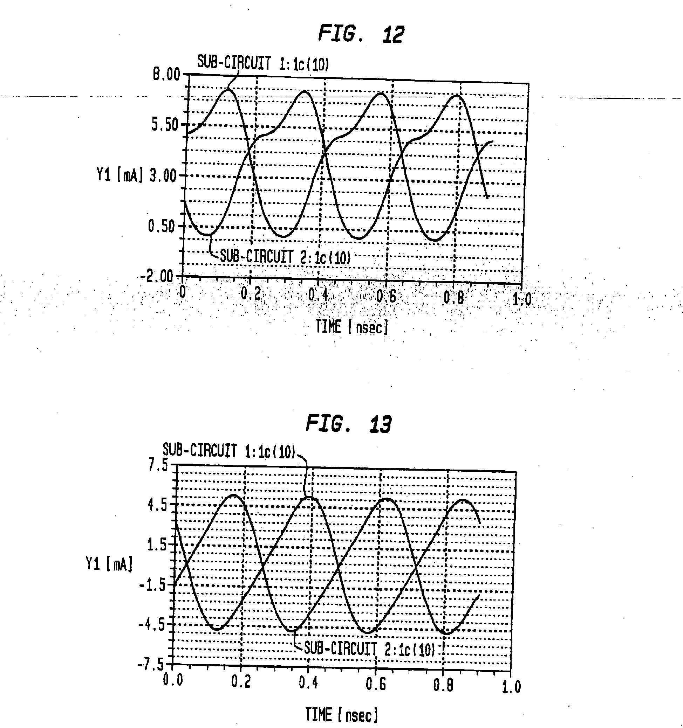

FIG. 12 is a plot of the RF-collector current of the circuitry depicted in FIG. 12.
FIG. 13 is a plot of the RF-collector current of the circuitry depicted in FIG. 12.

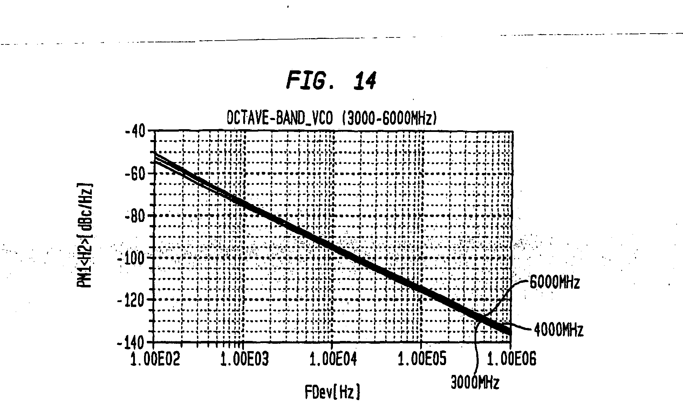

FIG. 14 illustrates a phase noise plot over an octave-band frequency range of 1.6 GHz to 3.2 GHz.

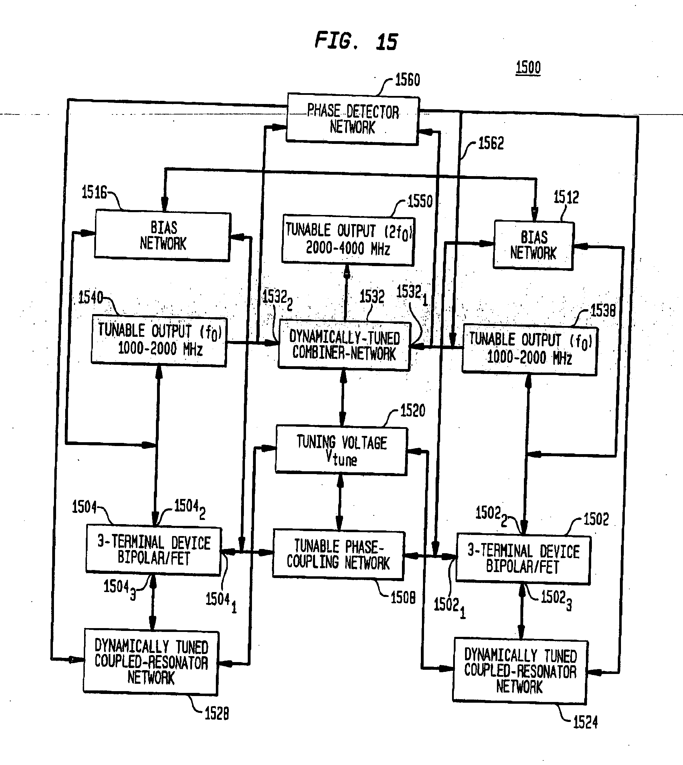

FIG. 15 is a functional block diagram illustrating the modules of an oscillator in accordance with an aspect of the present invention.

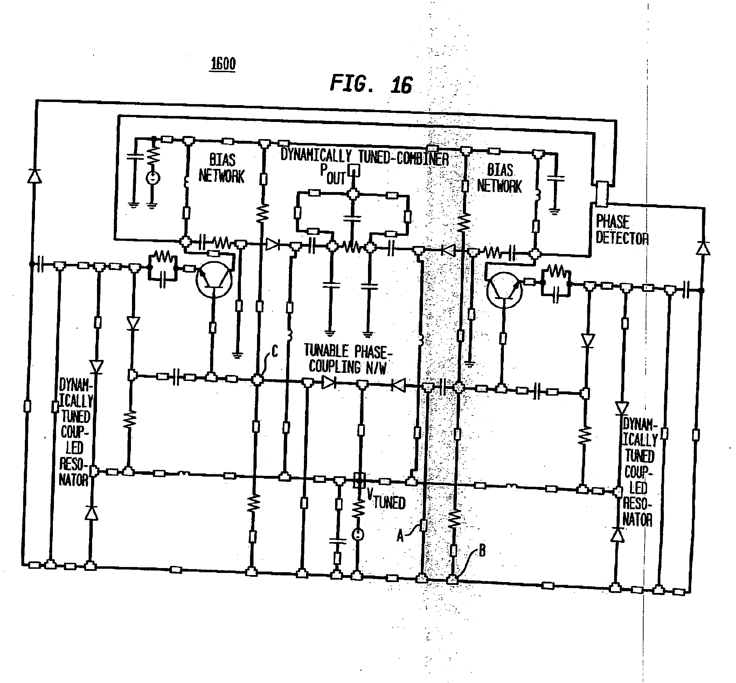

FIG. 16 is a schematic circuit diagram of a VCO showing some circuit implementation details of the present invention.

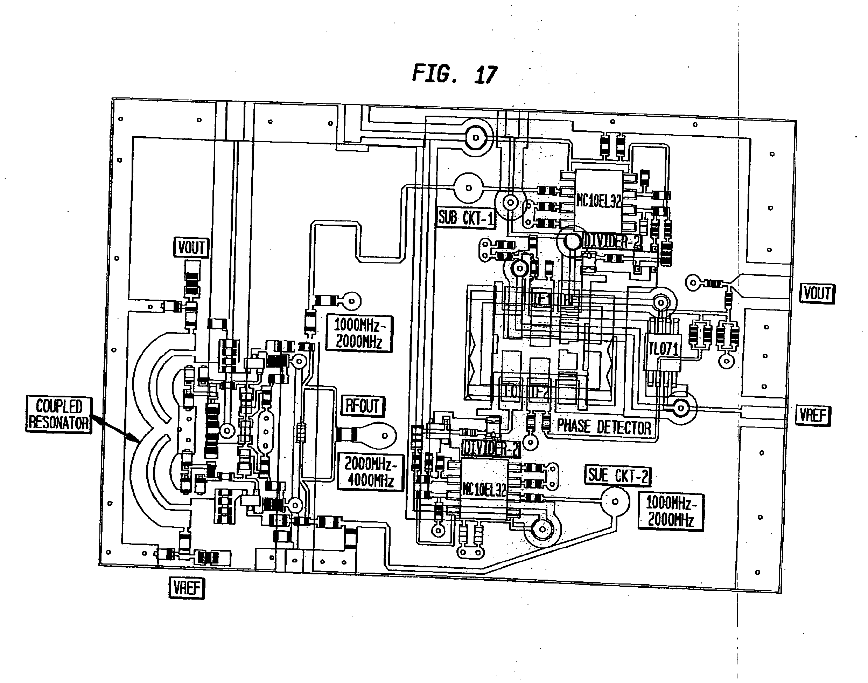

FIG. 17 is a schematic of an integrated circuit comprising a VCO showing some layout details of the present invention.

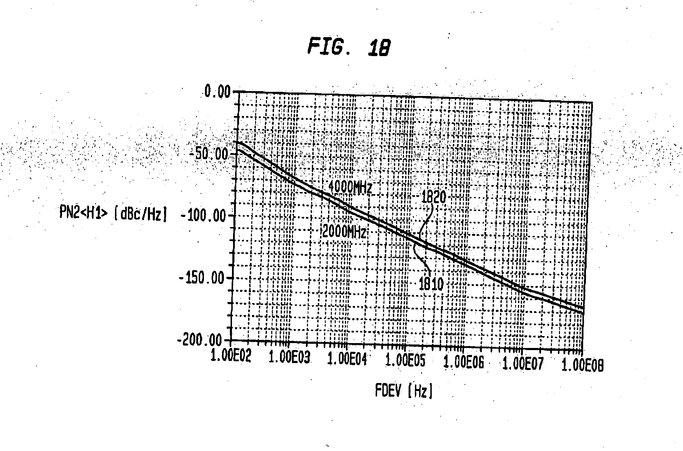

FIG. 18 illustrates a phase noise plot for a VCO in accordance with an aspect of the present invention.

### DESCRIPTION OF THE PREFERRED EMBODIMENTS

In one aspect, the present invention relates to circuitry for voltage controlled oscillators (VCOs). Preferably, such oscillators have one or more of the following characteristics: ultra-low phase noise performance, power efficient, low cost, tunable with more than octave-band tunability and amenable to integrated chip form.

FIG. 1 illustratively depicts a functional block diagram of the modules of a low noise octave-band voltage controlled oscillator (VCO) 100. The VCO 100 is shown as operating in the frequency range of 1000 - 2000 MHz/2000 - 4000 MHz (i.e., 1 GHz - 2 GHZ/2 GHz - 4Ghz), although the individual circuit parameters, e.g., resistor values, capacitor values, etc., may be selected and arranged so that the circuit operates at a different fundamental frequency and produces a tunable output at both the fundamental frequency and second harmonic. In addition, the topology shown in FIG. 1 may be extended from a push-push type configuration, such as 1 GHz - 2 GHz/2 GHz - 4 GHz/4 GHz - 8 GHz/8 GHz - 16 GHz, which allows the operating frequency of the oscillator to be extended beyond the cut-off frequency of the active device.

As FIG. 1 shows, the VCO/oscillator 100 includes a pair of three terminal devices, 102 and 104, which are coupled together through the other modules shown. More particularly, each device 102 and 104 includes three terminals, illustrated as 102₁, 102₂ and 102₃ and 104₁, 104₂ and 104₃, respectively. The first terminal 102₁ of first device 102 is coupled to a tunable phase coupling network 108 and bias network 112. The tunable phase coupling network 108 is also coupled to the first terminal 104₁ of the second device 104, which is also coupled to a bias network 116 at terminal 104₁. The tunable phase coupling network 108 is also coupled to tuning voltage block 120. The tuning voltage block 120 is coupled to dynamically tuned coupled-resonator networks, 124, 128, which are respectively coupled to the third terminals 102₃, 104₃ of each of the three terminal devices.

As discussed in U. S. Application No. 10/912,209, the three-terminal devices preferably comprise a bipolar transistor and wherein the first, second and third terminals of the three terminal device comprise either the collector, base and emitter nodes of the bipolar transistor. On the other hand, the three terminal device may comprise a field effect transistor wherein the first, second and third terminals of the three terminal device either comprise the collector, base and emitter nodes of the field effect transistor. As a general matter, the three terminal device desirably includes any three terminal device which is operable to provide a 180 degree phase shift between the first and second terminals.

The tuning voltage block 120 is further coupled to a dynamically-tuned combiner network 132, which includes two input ports, 132₁ and 132₂. Each of the input ports 132₁ and 132₂ accept input signals 138, 140 present at the second terminals 102₂ and 104₂ of each of the devices. The dynamically-tuned combiner network 132 combines the input signals 138, 140 and produces a signal 150 operating at the second harmonic of the input signals 138, 140.

The oscillator 100 preferably operates in the following manner. The circuit elements comprising the various modules, e.g., diodes, resistors, capacitors, resonators, etc., are selected so that each of the three terminal devices 102, 104 oscillate at a fundamental frequency, f0. As the voltage level of the tuning voltage module 120 is adjusted the fundamental frequency of operation, f0, appearing as input signals 138, 140 is tuned over the operating range of the oscillator, e.g., preferably octave-band. These signals 138, 140 are then combined in the combiner network 132 to produce a signal operating at twice the fundamental frequency, 2f0, and that is dynamically tuned as the voltage level of the tuning voltage module 120 is adjusted. A select portion of a signal 154 from the combiner network 132 is also fed back to the tuning block 120. A portion of the signal 154 is then fed to tunable phase coupling network 108 and used to dynamically tune the phase of the output signals 138, 140, so that each of these signals remain in phase during a tuning operation. In addition, a portion of the signal 154 is also fed to each of the dynamically-tuned coupled resonator networks 124, 128, so that the frequency, f0, present at block 138 is at the same frequency as the signal present at block 140. Accordingly, as the tuning voltage, Vtune, is adjusted the frequency of the signals, f0, present at each of the terminals 102₂ and 104₂ are tuned over the operating frequency band through the coupled resonator networks 124, 128, while the phase coupling network 108 keeps the two devices 102, 104 operating in an anti-phase mode at the fundamental frequency, f0 (e.g., push-pull behavior), while the second harmonic, 2f0, interferes constructively (e.g., push-push behavior) over the octave band.

FIG. 2 depicts a schematic circuit diagram 200 of a VCO designed in accordance with the principles of FIG. 1 In particular, FIG. 2 illustrates a dynamically tuned coupled-resonator network, dynamically tuned phase-coupling network and dynamically tuned combiner network for octave-band 2-Push/ Push-Push operation. As one of ordinary skill in the art may recognize, the rectangular blocks (e.g., A) in FIG. 2 (and the other circuit diagrams that comprise this disclosure) are transmission lines and coupling blocks (e.g., B or C) are three port (T-connector) or four port connecters or couplers that connected different circuit branches. Although FIG. 2 shows a 2-Push configuration the circuitry may be extended to a N-Push configuration and provide a tunable signal at N times the fundamental frequency of the sub-circuit's operation. The sub-circuits comprise the respective bias networks, resonator networks and three-terminal devices, which in this embodiment are depicted as bipolar transistors although FETs may be used also. The values of the individual circuit elements may chosen so that the resulting output signal from the circuitry operates in the L, S and C band and is tunable over a desired frequency band, preferably octave-band. This configuration is intended to overcome the limitations of the fixed frequency operation of the push-push oscillator/N-push oscillator by including a tuning and phase controlling network over the desired frequency band (preferably octave-band).

FIG. 3 illustrates a schematic layout of an integrated circuit (IC) 300 designed in accordance with the schematic circuit diagram of FIG. 2 with the values of the various circuit elements chosen such that the fundamental frequency is tunable over the frequency range of 1000 MHz to 2000 MHz (1 GHz to 2 GHz). In addition, the circuitry 300 also provides an output that is tunable over the frequency range of 2000 MHz to 4000 MHz (2 GHz to 4 GHz). As FIG. 3 shows, the functional diagram of FIG. 1 and the circuitry of FIG. 2 are amenable to implementation as an integrated circuit. More particularly, the integrated circuitry of FIG. 3 includes a printed microstripline resonator and various discrete elements that may be preferably implemented in Roger material.

FIG. 4 illustrates a schematic layout of another integrated circuit 400 in accordance with the schematic circuit diagram of FIG. 2. As in FIG. 3, the various components of FIG. 2 are chosen such that the fundamental frequency is tunable over the frequency range of 1 GHz to 2 GHz. In addition, the integrated circuit 400 also provides an output that is tunable over the frequency range of 2 GHz to 4 in a push-push topology and each of the dynamically tuned coupled resonators is provided in integrated circuit form. The form of the integrated circuit shown in FIG. 4 tends to be even more compact than that shown in FIG. 3.

As FIGS. 3 and 4 demonstrate a VCO may be implemented in the form of a compact integrated circuit, such as integrated circuits 300 and 400. The integrated circuits 300 and 400 may be advantageously mounted to a printed circuit or wire board in wireless devices, such as cell phones or a personal digital assistant, where space is at a premium. In addition, these devices preferably include octave band tunability, which allows for their deployment in applications such as WCDMA.

FIG. 5 illustrates a plot 500 of the RF-base currents of a voltage control oscillator of the type shown in FIGS. 3 or 4 at the fundamental frequency of operation. As FIG. 5 shows, the RF-base currents are out of phase for the fundamental frequency of the operation, 1000 - 2000 MHz.

FIG. 6 illustrates a typical phase noise plot 600 of an oscillator implemented in accordance with the circuitry illustrated in FIGS. 2, 3 or 4 for the octave-band frequency range of 2000 - 4000 MHz. As FIG. 6 shows the phase noise of the oscillator is approximately -90 dBc/Hz at 10 KHz over for the frequency band of 2000 - 4000 MHz. However, the integrated circuits 300, 400 typically provide better than -95 dBc/Hz at 10 KHz over for the frequency band of 2000 - 4000 MHz.

FIG. 7 is a functional block diagram illustrating the modules of a low noise octave-band VCO 700. As shown in FIG 7, the VCO includes a three terminal device 710 that includes terminals 710₁ if 710₂ and 710₃. The device 710 is preferably configured as a parallel emitter transistor. The first terminal 710₁ is coupled to a DC-bias and filtering network 716. The second terminal 710₂ is coupled to a wideband negative resistance network 720, which is also coupled to the first terminal 710₁ of the device 710. The third terminal 710₃ of the device 710 is coupled to a pair of dynamically tuned coupled-resonator tuning diode networks 726₁ and 726₂ preferably through the parallel emitter of a three-terminal bipolar transistor. In FIG. 7, the third terminal 710₃ is shown twice on the device in order to simply the diagram, yet while illustrating the parallel emitter configuration. A filtering and tuning voltage network 730 is coupled between the dynamically tuned coupled-resonator tuning diode networks 726₁ and 726ₐ. The output signal of the VCO 700 is taken from a matching and output network 740 coupled to the first terminal 710₁ of the device.

In operation, the wideband negative resistance generating network 720 maintains a constant resistance over the tuning band of the oscillator 700. More particularly, the filtering and tuning network 730 is tuned to adjust the oscillation frequency of the device 710 through the coupled-resonator and tuning diode 726. As tuning occurs the negative resistance generating network 720 maintains uniform or constant negative resistance over the tuning band. In this way, the phase noise output of the oscillator may be maintained at a relatively low, e.g., ultra-low, level.

FIG. 8A shows a schematic circuit diagram 800 of a possible implementation of the functional diagram 700 of FIG. 7. As FIG. 8A shows, a filter and tuning bias network 810 is integrated with a pair of coupled horse-shoe microstrip resonator (820₁ and 820₂). The tuning network 810 and negative resistance generating network 840 allows the VCO to be tunable over more than an octave-band while maintaining a uniform phase-noise performance through the band. The circuit elements are preferably chosen to provide tunability over a 1600 - 3200 MHz frequency band. The circuit elements may also be chosen to allow for tunability over other octave bands as is discussed below.

FIG. 8B illustrates a schematic circuit diagram 850 of a possible implementation of the functional diagram 700 of FIG. 7. The circuitry 850 of FIG. 8B includes a variable negative resistance generating network 860, which is preferably coupled to the base of a bipolar transistor 864. The transistor 864 is preferably arranged in a parallel emitter configuration with a pair of dynamically tuned coupled-resonators 868₁, 868₂ coupled in parallel to the emitter. A filter and tuning bias network 870 is coupled between the resonators 868₁ and 868₂ as shown. The negative resistance generating network includes a pair a variable capacitors that allow the negative resistance to be variable over the tuning range. This in turns allows the value of resistance provided by the network 860 to be tunable over the tuning range of the oscillator.

FIG. 9 illustrates a schematic layout of an integrated circuit 900 designed in accordance with the embodiment illustrated FIG. 8A. The discrete elements and layout of the integrated circuit of FIG. 9 may be chosen to allow for more than octave band tunability over a 1.6 to 3.2 GHz operating frequency range.

FIG. 10 shows a phase noise plot 1000 for the octave-band frequency range of 1600 - 3200 MHz for the integrated circuit 900 of FIG. 9. As shown, the phase noise is approximately - 95dBc at 10 KHz, however the phase noise is typically better than -100dBc at 10 KHz.

FIG. 11 depicts a schematic circuit diagram of a low noise octave band VCO 1100 operating in the frequency range of 3000 - 6000 MHz The circuit diagram of FIG. 11 is implemented in accordance with the functional diagram of the FIG. 1, however the circuit elements comprising the various modules are selected so as to provide a fundamental frequency of operation of 1500 to 3000 MHz. Accordingly, the second harmonic combiner network 1110 combines the signal at the fundamental frequency produced at the collectors, 1130₁ and 1130₂, of the transistors to produce a signal that is tunable over the frequency band of 3000 to 6000 MHz.

As FIG. 11 also shows, a dynamic tuning network 1134 which is integrated with coupled horse-shoe microstrip resonators 1138₁ and 1138₂ is incorporated to get more than octave band tunability while maintaining a uniform phase noise performance throughout the band.

FIG. 12 is a plot 1200 of the RF-collector current of both sub-circuits of FIG. 11, which are out of phase for the fundamental frequency of operation, 1500 - 3000 MHz.

FIG. 13 is a plot 1300 of the RF-base currents of both sub-circuits of FIG. 11, which are out of phase for the fundamental (undesired frequency of the operation, 1500 - 3000 MHz. FIG. 14 shows a phase noise plot 1400 for octave-band frequency range of 3000 - 6000 MHz for the circuitry shown in FIG. 11.

Turning now to FIG. 15, there is illustrated a VCO or oscillator 1500. The VCO 1500 is shown as operating in the frequency range of 1 GHz - 2 GHz/2 GHz - 4GHz, although the individual functional blocks and their accompanying circuit parameters, e.g., resistor values, capacitor values, etc., may be selected and arranged so that the circuit operates at a different fundamental frequency and produces a tunable output at both the fundamental frequency and second harmonic. In addition, the topology shown in FIG. 15 may be extended from a push-push type configuration, such as 1 GHz - 2 GHz/2 GHz - 4 GHz/4 GHz - 8 GHz/8 GHz - 16 GHz, which allows the operating frequency of the oscillator to be extended beyond the cut-off frequency of the active device.

As FIG. 15 shows, the VCO/oscillator 1500 includes a pair of three terminal devices, 1502 and 1504, which are coupled together through the other modules shown. More particularly, each device 1502 and 1504 includes three terminals, illustrated as 1502₁, 1502₂ and 1502₃ and 1504₁, 1504₂ and 1504₃, respectively. The first terminal 1502₁ of first device 1502 is coupled to a tunable phase coupling network 1508 and bias network 1512. The tunable phase coupling network 1508 is also coupled to the first terminal 1504₁ of the second device 1504, which is also coupled to a bias network 1516 at terminal 1504₁. The tunable phase coupling network 1508 is also coupled to tuning voltage block 1520. The tuning voltage block 1520 is coupled to dynamically tuned coupled resonator networks, 1524, 1528, which are respectively coupled to the third terminals 1502₃, 1504₃ of each of the three terminal devices.

As discussed above, the three-terminal devices preferably comprise a bipolar transistor, wherein the first, second and third terminals of the three terminal device comprise the collector, base and emitter nodes of the bipolar transistor. On the other hand, the three terminal device may comprise a field effect transistor, wherein the first, second and third terminals of the three terminal device comprise the collector, base and emitter nodes of the field effect transistor. As a general matter, the three terminal device desirably includes any three terminal device that is operable to provide a 180 degree phase shift any two terminals.

The tuning voltage block 1520 is further coupled to a dynamically-tuned combiner network 1532, which includes two input ports, 1532₁ and 1532₂. Each of the input ports 1532i and 1532₂ accept input signals 1538, 1540 present at the second terminals 1502₂ and 1504₂ of each of the devices. The dynamically-tuned combiner network 1532 combines the input signals 1538, 1540 and produces a signal 1550 operating at the second harmonic of the input signals 1538, 1540.

The oscillator 1500 further includes a phase detecting network or phase detector 1560 coupled between resonator networks 1524, 1528 and combiner network 1532, as shown. The phase detector network 1560 may be realized by using a divider, amplifier and balanced mixers arranged in a conventional manner. The divider may comprise MC10EL32, made by ON Semiconductor, Inc., and the amplifier and balanced mixes may, respectively, comprise OPAMP TL071 from Texas Instruments and mixers available from Synergy Microwave, the assignee of the present invention. The phase detector network 1560 dynamically compensates for phase errors between each oscillator during wideband operation. The phase detector network 1560 detects random fluctuations in the free-running frequency and translates those fluctuations into phase errors. The phase errors are then fed back to the combiner network 1532 (see line 1562) and used to control the phase and frequency of the output signal 1550 during tuning operation. The phase errors are also fed back to the dynamically tuned coupled resonator networks 1524, 1528 and used to tune the oscillating frequencies of the each of the three terminal devices.

The oscillator 1500 preferably operates in the following manner. The circuit elements comprising the various modules, e.g., diodes, resistors, capacitors, resonators, etc., are selected so that each of the three terminal devices 1502, 1504 oscillate at a fundamental frequency, f0. As the voltage level of the tuning voltage module 1520 is adjusted the fundamental frequency of operation, f0, appearing as input signals 1538, 1540 is tuned over the operating range of the oscillator, e.g., preferably octave-band. These signals 1538, 1540 are then combined in the combiner network 1532 to produce a signal operating at twice the fundamental frequency, 2f0, and that is dynamically tuned as the voltage level of the tuning voltage module 1520 is adjusted. A select portion of a signal 1554 from the combiner network 1532 is also fed back to the tuning block 1520. A portion of the signal 1554 is then fed to tunable phase coupling network 1508 and used to dynamically tune the phase of the output signals 1538, 1540, so that each of these signals remain in phase during a tuning operation. A portion of the signal 1554 is also fed to each of the dynamically-tuned coupled resonator networks 1524, 1528, so that the frequency, f0, present at block 1538 is at the same frequency as the signal present at block 1540. Accordingly, as the tuning voltage, Vₜᵤₙₑ, is adjusted the frequency of the signals, f0, present at each of the terminals 1502₂ and 1504₂ are tuned over the operating frequency band through the coupled resonator networks 1524, 1528, while the phase coupling network 1508 keeps the two devices 1502, 1504 operating in an anti-phase mode at the fundamental frequency, f0 (e.g., push-pull behavior), while the second harmonic, 2f0, interferes constructively `(e.g., push-push behavior) over the octave band. In addition, the phase detector network 1560 operates as described above to dynamically compensate for phase errors during wideband operation.

FIG. 16 depicts a schematic circuit diagram 1600 of a VCO designed in accordance with the principles of FIG. 15 In particular, FIG. 16 illustrates a dynamically tuned coupled-resonator network, dynamically tuned phase-coupling network, dynamically tuned phase detector and dynamically tuned combiner network for octave-band 2-Push/Push-Push operation. As one of ordinary skill in the art may recognize, the rectangular blocks (e.g., A) in FIG. 16 (and the other circuit diagrams that comprise this disclosure) are transmission lines and coupling blocks (e.g., B or C) are three port (T-connector) or four port connecters or couplers that connected different circuit branches. Although FIG. 16 shows a 2-Push configuration the circuitry may be extended to a N-Push configuration and provide a tunable signal at N times the fundamental frequency of the sub-circuit's operation. The sub-circuits comprise the respective bias networks, resonator networks and three-terminal devices, which in this embodiment are depicted as bipolar transistors although FETs may be used also. The values of the individual circuit elements may be chosen so that the resulting output signal from the circuitry operates in the L, S and C band and is tunable over a desired frequency band, preferably octave-band. This configuration is intended to overcome the limitations of the fixed frequency operation of the push-push oscillator/N-push oscillator by including a tuning and phase controlling network over the desired frequency band (preferably octave-band).

FIG. 17 illustrates a schematic layout of an integrated circuit (IC) 1700 designed in accordance with the schematic circuit diagram of FIG. 16 with the values of the various circuit elements chosen such that the fundamental frequency is tunable over the frequency range of 1000 MHz to 2000 MHz (1 GHz to 2 GHz). In addition, the circuitry 1700 also provides an output that is tunable over the frequency range of 2000 MHz to 4000 MHz (2 GHz to 4 GHz). As FIG. 17 shows, the functional diagram of FIG. 15 and the circuitry of FIG. 16 are amenable to implementation as an integrated circuit. More particularly, the integrated circuitry of FIG. 17 includes a printed microstripline resonator and various discrete elements that may be preferably implemented in Roger material.

Turning now to FIG. 18, there is shown a phase noise plot of a VCO designed and operating in accordance with FIG. 15. As FIG. 18 shows, the phase noise is approximately -95 dBc/Hz at 10 KHz (line 1810) for the fundamental frequency of operation and better than -90 dBc/Hz at 10 KHz (line 1820) for the second harmonic signal.

Circuitry and methods for correcting the phase in a coupled oscillator system are provided. In view of the limitations of the known microwave active devices and resonators for wideband operation, in one aspect the present invention provides a circuit topology, which supports wideband tunability in a compact size that is amenable for integration in an integrated circuit or chip form. The random fluctuations in the free-running frequency due to the fabrication tolerances of the components are translated into the phase errors. For ultra low phase noise operation in the coupled oscillator system, it is desirable to minimize the phase errors by making the free-running frequencies of the oscillators agree as tightly possible. The difference between the oscillator free-running frequencies and the array ensemble frequency of the coupled oscillator systems is compensated by a feedback network (phase detector circuit), which provides a correction voltage corresponding to the phase-shift of a tuning diode network integrated with the common resonator circuit.

A voltage controlled oscillator implemented in accordance with the present invention may be employed in any number of devices that are used to communicate on data, telephone, cellular or, in general, communications network. Such devices may include but are not limited to, for example, cellular phones, personal digital assistants, modem cards, lap tops, satellite telephones. As a general matter, the oscillator circuitry shown in the various drawings and described above may be employed in a PLL to either generate a clock signal that may be used to transmit or recover information transmitted or received over a network. In addition to wireless networks, the circuitry of the present invention may be employed in wired networks, satellite networks, etc.

Although the invention herein has been described with reference to particular embodiments, it is to be understood that these embodiments are merely illustrative of the principles and applications of the present invention. It is therefore to be understood that numerous modifications may be made to the illustrative embodiments and that other arrangements may be devised without departing from the scope of the present invention as defined by the appended claims.

## Claims

1. A voltage controlled oscillator, comprising:
a first transistor (1502) having first (1502₁), second (1502₂) and third terminals (1502₃);
a second transistor (1504) having first (1504₁), second (1504₂) and third terminals (1504₃);
**characterized by**
a circuitry comprising dynamically tuned coupled resonator networks (1524, 1528) coupled to the first terminals (1502₁, 1504₁) of each of the transistors (1502, 1504) through a tuning voltage network (1520) and a tunable phase coupling network (1508), and further coupled to the third terminals (1502₃, 1504₃) of each of the transistors (1502, 1504);
a dynamically tuned combiner network (1532) coupled between the second terminals (1502₂, 1504₂) of each of the transistors (1502, 1504) to combine output signals (1538, 1540) present at the second terminals (1502₂, 1504₂) into a signal (1550) operating at the second harmonic of the output signals (1538, 1540); and
a phase detector (1560) coupled between the dynamically tuned coupled resonator networks (1524, 1528) and the dynamically tuned combiner network (1532), configured to detect phase errors that occur between the output signals (1538, 1540) present at the second terminals (1502₂, 1504₂) of the first transistor (1502) and the second transistor (1504) and is operable to dynamically compensate by feeding back a signal based on the phase errors to the dynamically tuned combiner network (1532) and to the dynamically tuned coupled resonator networks (1524, 1528) during wideband operation so that each of the output signals (1538, 1540) remains in phase during a tuning operation,
wherein the dynamically tuned coupled resonator networks (1524, 1528) comprise a pair of micro-strip coupled resonators arranged in a horse-shoe configuration, and wherein the voltage of the tuning network (1520) can be adjusted to tune an output signal (1538, 1540, 1550) of the voltage controlled oscillator over at least an octave frequency band by feeding back said signal based on the phase errors to the tunable phase coupling network (1508), which keeps the first and second transistors (1502, 1504) operating in an anti-phase mode at an operating frequency of the output signals (1538, 1540) while the second harmonic interferes constructively over the octave band and to the dynamically tuned coupled resonator networks (1524, 1528) for tuning the phases and frequency respectively of the first (1502) and second (1504) transistors.

2. The voltage controlled oscillator of claim 1,
further comprising a bias network (1512, 1516) coupled between the first (1502₁, 1504₁) and second terminals (1502₂, 1504₂) of the first (1502) and second (1504) transistors.

3. The voltage controlled oscillator of claim 1,
wherein the first (1502) and second (1504) transistors each comprise bipolar transistors.

4. The voltage controlled oscillator of claim 1,
wherein the first (1502) and second (1504) transistors each comprise field effect transistors.

5. The voltage controlled oscillator of claim 1,
wherein the first transistor (1502), second transistor (1504) and circuitry (1524, 1528) are implemented in an integrated circuit.

6. The voltage controlled oscillator of claims 1 to 5,
wherein the first (1502) and second (1504) transistors are arranged in a push-push configuration.

7. The voltage controlled oscillator of claims 1 to 6,
wherein the tuning voltage network (1520) comprises first and second tuning diode networks coupled to the first (1502) and second (1504) transistors for dynamically adjusting the operating frequency of output signals (1538, 1540) of the first (1502) and second (1504) transistors.

8. The voltage controlled oscillator of claim 7,
wherein the phase detector (1560) is integrated with the first and second tuning diode networks.

9. A network communication device, the device comprising:
a phase lock loop for generating a clock signal used to transmit or recover information communicated from or to the device,
wherein the phase lock loop includes a voltage controlled oscillator corresponding to claims 1 to 8 for generating the clock signal.

10. The communication device of claim 9,
wherein the communication device comprises a wireless device.

11. The communication device of claim 9,
wherein the wireless device is a cellular telephone.

12. The communication device of claim 9,
wherein the wireless device is a personal digital assistant.

## Patentansprüche

1. Spannungsgesteuerter Oszillator, mit:
einem ersten Transistor (1502), der einen ersten (1502₁), einen zweiten (1502₂) und einen dritten Anschluss (1502₃) aufweist;
einem zweiten Transistor (1504), der einen ersten (1504₁), einen zweiten (1504₂) und einen dritten Anschluss (1504₃) aufweist;
**gekennzeichnet durch**
einen Schaltkreis mit dynamisch abgestimmten, gekoppelten Resonator-Netzwerken (1524, 1528), die jeweils mit dem ersten Anschluss (1502₁, 1504₁) der Transistoren (1502, 1504) über ein Abstimmungsspannungsnetzwerk (1520) und ein abstimmbares Phasenkopplungsnetzwerk (1508) gekoppelt sind, und die weiterhin jeweils mit dem dritten Anschluss (1502₃, 1504₃) der Transistoren (1502, 1504) gekoppelt sind;
ein dynamisch abgestimmtes Kombinationsnetzwerk (1532), das jeweils zwischen den zweiten Anschlüssen (1502₂, 1504₂) der Transistoren (1502, 1504) gekoppelt ist, um an den zweiten Anschlüssen (1502₂, 1504₂) vorliegende Ausgangssignale (1538, 1540) zu einem Signal (1550) zu kombinieren, das mit der zweiten Oberschwingung der Ausgangssignale (1538, 1540) arbeitet; und
einem zwischen den dynamisch abgestimmten, gekoppelten Resonator-Netzwerken (1524, 1528) und dem dynamisch abgestimmten Kombinationsnetzwerk (1532) gekoppelten Phasendetektor (1560), der dazu konfiguriert ist, Phasenfehler zu erfassen, die zwischen den an den zweiten Anschlüssen (1502₂, 1504₂) des ersten Transistors (1502) und des zweiten Transistors (1504) vorliegenden Ausgangssignalen (1538, 1540) auftreten, und zu einem dynamischen Ausgleich betätigbar ist, indem er ein Signal auf der Basis der Phasenfehler im Breitbandbetrieb an das dynamisch abgestimmte Kombinationsnetzwerk (1532) und an die dynamisch abgestimmten, gekoppelten Resonator-Netzwerke (1524, 1528) rückkoppelt, so dass die Ausgangssignale (1538, 1540) jeweils während eines Abstimmvorgangs in Phase bleiben,
wobei die dynamisch abgestimmten, gekoppelten Resonator-Netzwerke (1524, 1528) ein Paar von in Mikrostreifen-gekoppelten und hufeisenförmig angeordneten Resonatoren umfassen, und
wobei die Spannung des Abstimmnetzwerks (1520) so eingestellt werden kann, dass es ein Ausgangssignal (1538, 1540, 1550) des spannungsgesteuerten Oszillators über mindestens ein Oktavfrequenzband abstimmt, indem es das Signal auf der Basis der Phasenfehler an das abstimmbare Phasenkopplungsnetzwerk (1508), das die in einem Gegenphasenmodus arbeitenden, ersten und zweiten Transistoren (1502, 1504) auf einer Betriebsfrequenz der Ausgangssignale (1538, 1540) hält, während die zweite Oberschwingung das Oktavband konstruktiv überlagert, sowie an die dynamisch abgestimmten, gekoppelten Resonator-Netzwerke (1524, 1528) rückkoppelt, um die Phasen und Frequenzen des ersten (1502) bzw. zweiten (1504) Transistors abzustimmen.

2. Spannungsgesteuerter Oszillator nach Anspruch 1,
weiterhin mit einem Vorspannungsnetzwerk (1512, 1516), das zwischen den ersten (1502₁, 1504₁) und den zweiten Anschlüssen (1502₂, 1504₂) des ersten (1502) und des zweiten (1502) Transistors gekoppelt ist.

3. Spannungsgesteuerter Oszillator nach Anspruch 1,
wobei der erste (1502) und der zweite (1504) Transistor jeweils bipolare Transistoren aufweist.

4. Spannungsgesteuerter Oszillator nach Anspruch 1,
wobei der erste (1502) und der zweite (1504) Transistor jeweils Feldeffekttransistoren aufweist.

5. Spannungsgesteuerter Oszillator nach Anspruch 1,
wobei der erste Transistor (1502), der zweite Transistor (1504) und der Schaltkreis (1524, 1528) in einer integrierten Schaltung implementiert sind.

6. Spannungsgesteuerter Oszillator nach den Ansprüchen 1 bis 5,
wobei der erste (1502) und der zweite (1504) Transistor in einer Push-push Konfiguration angeordnet sind.

7. Spannungsgesteuerter Oszillator nach den Ansprüchen 1 bis 6,
wobei das Abstimmspannungsnetzwerk (1520) erste und zweite Abstimmdioden-Netzwerke aufweist, welche mit dem ersten (1502) und dem zweiten (1504) Transistor gekoppelt sind, um die Betriebsfrequenz von Ausgangssignalen (1538, 1540) des ersten (1502) und des zweiten (1504) Transistors dynamisch einzustellen.

8. Spannungsgesteuerter Oszillator nach Anspruch 7,
wobei der Phasendetektor (1560) in das erste und das zweite Abstimmdioden-Netzwerk integriert ist.

9. Netzwerkkommunikationsvorrichtung, wobei die Vorrichtung Folgendes aufweist:
einen Phasenregelkreis zur Erzeugung eines Taktsignals, das zur Übertragung oder Wiedergewinnung von Informationen verwendet wird, die von der oder an die Vorrichtung kommuniziert werden,
wobei der Phasenregelkreis einen spannungsgesteuerten Oszillator entsprechend den Ansprüchen 1 bis 8 zur Erzeugung des Taktsignals aufweist.

10. Kommunikationsvorrichtung nach Anspruch 9,
wobei die Kommunikationsvorrichtung eine drahtlose Vorrichtung aufweist.

11. Kommunikationsvorrichtung nach Anspruch 9,
wobei die drahtlose Vorrichtung ein Mobiltelefon ist.

12. Kommunikationsvorrichtung nach Anspruch 9,
wobei die drahtlose Vorrichtung ein Personal Digital Assistant ist.

## Revendications

1. Oscillateur commandé en tension, comportant :
un premier transistor (1502) ayant des première (1502₁), deuxième (1502₂) et troisième (1502₃) bornes ;
un second transistor (1504) ayant des première (1504₁), deuxième (1504₂) et troisième (1504₃) bornes ;
**caractérisé par**
des circuits comportant des réseaux de résonateurs couplés et accordés dynamiquement (1524, 1528) couplés aux premières bornes (1502₁, 1504₁) de chacun des transistors (1502, 1504) via un réseau de tension d'accord (1520) et un réseau de couplage de phase accordable (1508), et en outre couplés aux troisièmes bornes (1502₃, 1504₃) de chacun des transistors (1502, 1504) ;
un réseau de combinateurs accordés dynamiquement (1532) couplé entre les deuxièmes bornes (1502₂, 1504₂) de chacun des transistors (1502, 1504) pour combiner des signaux de sortie (1538, 1540) présents aux deuxièmes bornes (1502₂, 1504₂) en un signal (1550) fonctionnant à la seconde harmonique des signaux de sortie (1538, 1540) ; et
un détecteur de phase (1560) couplé entre les réseaux de résonateurs couplés et accordés dynamiquement (1524, 1528) et le réseau de combinateurs accordés dynamiquement (1532), configuré pour détecter des erreurs de phase qui apparaissent entre les signaux de sortie (1538, 1540) présents aux deuxièmes bornes (1502₂, 1504₂) du premier transistor (1502) et du second transistor (1504) et peut fonctionner pour les compenser dynamiquement en réinjectant un signal basé sur les erreurs de phase dans le réseau de combinateurs accordés dynamiquement (1532) et dans les réseaux de résonateurs couplés et accordés dynamiquement (1524, 1528) pendant un fonctionnement en large bande de sorte que chacun des signaux de sortie (1538, 1540) reste en phase pendant une opération d'accord, dans lequel les réseaux de résonateurs couplés et accordés dynamiquement (1524, 1528) comportent une paire de résonateurs microrubans couplés, agencés dans une configuration en fer à cheval, et dans lequel la tension du réseau d'accord (1520) peut être réglée pour accorder un signal de sortie (1538, 1540, 1550) de l'oscillateur commandé en tension sur au moins une bande d'octave de fréquences en réinjectant ledit signal basé sur les erreurs de phase dans le réseau de couplage à phase accordable (1508), ce par quoi les premier et second transistors (1502, 1504) continuent à fonctionner dans un mode en opposition de phase à une fréquence de fonctionnement des signaux de sortie (1538, 1540) alors que la seconde harmonique interfère de manière constructive sur la bande d'octave, et dans les réseaux de résonateurs couplés et accordés dynamiquement (1524, 1528) pour accorder les phases et la fréquence respectivement des premier (1502) et second (1504) transistors.

2. Oscillateur commandé en tension selon la revendication 1, comportant en outre un réseau de polarisation (1512, 1516) couplé entre les premières (1502₁, 1504₁) et deuxièmes (1502₂, 1504₂) bornes des premier (1502) et second (1504) transistors.

3. Oscillateur commandé en tension selon la revendication 1, dans lequel les premier (1502) et second (1504) transistors comportent chacun des transistors bipolaires.

4. Oscillateur commandé en tension selon la revendication 1, dans lequel les premier (1502) et second (1504) transistors comportent chacun des transistors à effet de champ.

5. Oscillateur commandé en tension selon la revendication 1,
dans lequel le premier transistor (1502), le second transistor (1504) et les circuits (1524, 1528) sont mis en œuvre dans un circuit intégré.

6. Oscillateur commandé en tension selon les revendications 1 à 5,
dans lequel les premier (1502) et second (1504) transistors sont agencés dans une configuration "push-push".

7. Oscillateur commandé en tension selon les revendications 1 à 6,
dans lequel le réseau de tension d'accord (1520) comporte des premier et second réseaux de diodes d'accord couplés aux premier (1502) et second (1504) transistors pour régler dynamiquement la fréquence de fonctionnement des signaux de sortie (1538, 1540) des premier (1502) et second (1504) transistors.

8. Oscillateur commandé en tension selon la revendication 7,
dans lequel le détecteur de phase (1560) est intégré aux premier et second réseaux de diodes d'accord.

9. Dispositif de communication en réseau, le dispositif comportant :
une boucle à phase asservie pour générer un signal d'horloge utilisé pour transmettre ou récupérer des informations communiquées depuis ou vers le dispositif,
dans lequel la boucle à phase asservie inclut un oscillateur commandé en tension correspondant aux revendications 1 à 8 pour générer le signal d'horloge.

10. Dispositif de communication selon la revendication 9,
dans lequel le dispositif de communication comporte un dispositif sans fil.

11. Dispositif de communication selon la revendication 9,
dans lequel le dispositif sans fil est un téléphone cellulaire.

12. Dispositif de communication selon la revendication 9,
dans lequel le dispositif sans fil est un assistant numérique personnel.
